Europäisches Patentamt

European Patent Office

Office européen des brevets

(19)

(11) **EP 1 067 688 A2**

(12) **EUROPEAN PATENT APPLICATION**

(43) Date of publication:
**10.01.2001 Bulletin 2001/02**

(51) Int Cl.⁷: **H03H 17/06**

(21) Application number: **00305481.4**

(22) Date of filing: **29.06.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventor: **Hudson, John E.**<br>**Stansted, Essex CM24 8LR (GB)** |
| (30) Priority: **29.06.1999 US 342358** | (74) Representative: **Dearling, Bruce Clive et al**<br>**Hepworth Lawrence Bryer & Bizley,**<br>**Merlin House,**<br>**Falconry Court,**<br>**Bakers Lane** |
| (71) Applicant: **Nortel Networks Limited**<br>**Montreal, Quebec H2Y 3Y4 (CA)** | **Epping, Essex CM16 5DQ (GB)** |

(54) **Digital filter and method of providing channel isolation in a radio frequency communication system**

(57) To reduce processing load, FIG. 9 is representative of a filter configuration of the present invention. Essentially, a receive (460) and/or transmit (455) chain contains a multi-rate filter (456, 462) configured as a decimator or interpolator, respectively. In use, the multi-rate filter (456, 462) provides approximation of a desired impulse frequency response characteristic (e.g. root-raised cosine) within a radio frequency signal processing chain. The multi-rate filter (456, 462) may be cocatenated (in series) with a conventional FIR filter (458, 464), such that the respective filters provide an anti-alias function and a band-pass function having well-defined impulse response characteristics. Signals either incident to a multi-rate interpolator or exiting from a multi-rate decimator are at about a factor of three times the symbol/chip rate and preferably at about twice the symbol/chip rate. Consequently, the FIR filter (458, 464) operates at a low sampling rate with respect to the multi-rate filter, with the FIR filter provide RRC (or other desired characteristic) spectral shaping.

# Fig.9.

**Description**

<u>Field Of The Invention</u>

The present invention relates, in general, to digital filters supporting a raised cosine function and is particularly, but not exclusively, applicable to the use of such filters in providing channel isolation in a radio frequency communication system, such as a CDMA or third generation cellular environments. More particularly, the present invention relates to a mult-rate matched filter, employing concatenation, in a receiver chain of a communication device, especially a mobile subscriber unit.

<u>Background Of The Invention</u>

Raised cosine (pulse) filtering, including derivatives thereof, is almost universally used in digital communication systems, including satellite modems, second generation cellular systems (GSM, DAMPS, IS95), and third generation cellular systems (UTRA and CDMA2000). Implemented within a finite impulse response (FIR) filter, a raised cosine characteristic provides very precise frequency characteristics that, in a time domain representation, have equally spaced zero-crossing points. Moreover, the zero-crossing points occur at a per symbol basis such that symbols adjacent a sampled symbol provide no interference. In other words, adjacent symbols are subject to a null (i.e. a zero-crossing point) when a sampled symbol is at its peak level.

What is generally thought to be the 'ideal spectrum' by research engineers in communications networks is not necessarily preferred in actual radio communications networks. Indeed, the raised cosine spectrum is preferred since the tails of the filter coefficients (in its time domain digital filter realisation) fall away more rapidly and spectral distortion caused by truncation of the filter creates less of a problem. Nevertheless, there are problems associated with the provision of such filters.

Conceptualising a time domain Fourier transform of a raised cosine FIR filter response ($\sqrt{H(f)}$) at eight samples per chip, there are effectively eight samples from a maxima (at zero) to a zero-crossing point on each side of zero, and such that the symbol space effectively includes seventeen sample points (8+zero+8) between zero-crossings. Each sample point corresponds to a tap required in the FIR filter.

Unfortunately, for example, in order to avoid aliasing of frequency components out-of-band, the FIR filter must have an infinitely extended response in the time domain; this is clearly not possible. Consequently, low-pass FIR filters are designed with a truncation in the number of taps used (on either side of zero) within the filter; each tap representing a different weighting coefficient that is applied to a sample. Increasing the number of taps therefore improves accuracy and effectiveness of the FIR filter, with a resultant characteristic having improved spectral isolation and less aliasing into adjacent frequency bands. A significant set-back occurs with implementation of FIR filters, namely that the each sample applied to an input of the FIR filter must be subject to each tap. In a typical CDMA-type system, by way of example, there are eight samples per chip and a chip rate typically in excess of 1MHz; this results in significant workload for a digital signal processor.

The practical problems with hardware implementation of filters, such as the raised cosine digital filters, are twofold. The root impulse response typically needs to be highly over-sampled to reduce spectral aliases; over-sampling of four or eight times per channel symbol is common. Aliases generally degrade the adjacent channel selectivity of the receiver and must be well controlled, whilst a truncation of the number of taps at each end reduces computation load but introduces side lobes into the frequency domain.

In other words, in a FIR filter, processing load is proportional to the number of taps, with each tap operating at the nominal sampling rate. Moreover, in a mobile environment, battery drain is proportional to workload, and so the advantages obtained through mobility (which are dependent upon power consumption and hence battery life) must be offset by increasing system interference through the use of a sub-optimal FIR filter. Clearly, co-channel interference must, however, satisfy system operational standards, and so there is again a trade-off between battery life and a system interference environment.

These problems are also inter-linked. Specifically, ilf the sample rate is increased by N-fold in order to provide the requisite degree of over-sampling, the number of taps required to span a certain time interval and maintain the frequency response also increases by N-fold. Consequently, there is a resultant $N^2$-fold increase in computation load. Thus, filters designed using straightforward FIR filtering can be very expensive.

It has been realised, especially in wideband and third generation radio frequency (RF) systems, that attaining defined rejection levels for co-channel interference is a particular problem. Moreover, a particular problem in CDMA-type systems occurs when a subscriber unit is affiliated to (or otherwise establishes a connection with) a base station in a cell remote to the physically nearest 'near-in' base station; with such connection not being subject to any soft-handover process. This is analogous to a co-channel interference situation arising from a subscriber unit close to a base station of a different operator, in which the base station operates in a contiguous frequency band. The subscriber unit receives service from a physically distant 'far-away' base station to overcome such things as log-normal fading; this is not a problem. But, in order to communicate effectively with the far-away base station and to obtain a minimum QoS (quality of service), the subscriber unit necessarily transmits at a relatively high power (significantly greater than that which would otherwise be set for communication with a near-in base station). However, the transmitting subscriber unit (in view of the limitation imposed on its filter isolation capabilities, now causes significant interference to the near-in base-station. This is the so-called "near-far" problem. In worst case scenarios, there is an escalation in transmit power levels in at least one of the systems (or order to continue to provide a desired QoS) with the result that network operation collapses and the system needs to be reset. Also, with increasing power, intermodulation becomes increasingly problematic

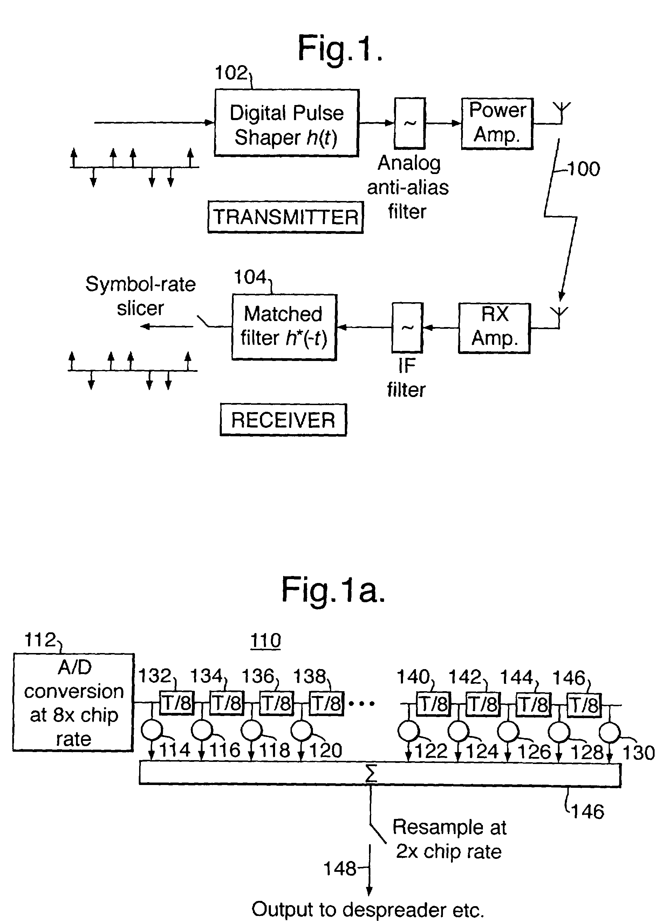

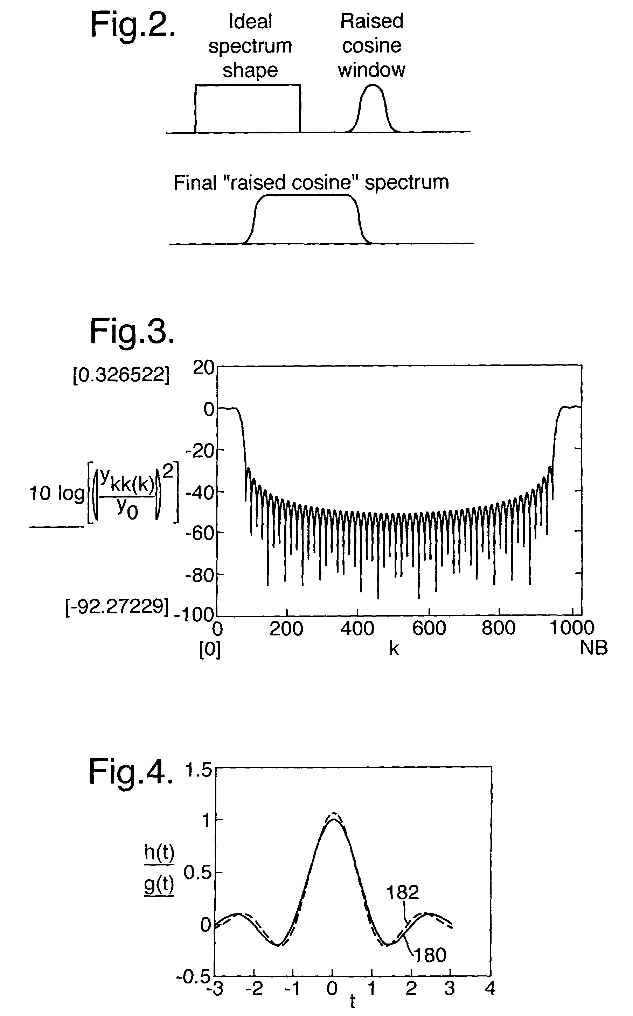

At a transmitter, the principle employed is that digital data symbols are represented as impulses. Digital data symbols typically cannot be transmitted as such because of their wide bandwidth and accordingly are shaped into smooth band-limited pulses before being passed to a modulator stage within a transmitter. The spectrum of these pulses then defines the spectral shape of the transmission in the radio channel. FIG. 1 shows some of the stages involved in the transmission and reception of radio signals 100, essentially as viewed from a start point of a digital pulse shaper 102 in a transmitter chain. In a receiver chain, raised cosine (matched) filtering is used to shape received pulses that have been amplified and generally converted and filtered into an intermediate frequency. As will be appreciated, the digital pulse shaping filter 102 (of the transmit chain) and the matched filter 104 (of the receiver chain) together form the raised cosine function H(f), with the matched filter 104 taking the form of a time-reversed replica of the pulse shaping function, i.e. $H(f)=\sqrt{H(f)}\sqrt{H^*(f)}$. The product of the transmitter and receiver spectrum H(f) is synthesised by convolving an ideal square spectral shape with a raised cosine, as shown in FIG. 2.

FIG. 1a shows a typical structure of a FIR filter in which digital signals 110 form an A/D converter 112 are applied to filter taps 114-130 having weighting coefficients. Digital time delays (T/8) 132-146, proportional to a chip rate for the system separate adjacent taps 114-130. Outputs from the taps are summed together in summer 146 that provides an output 148 to a symbol sampler, etc. (not shown). As will now be appreciated, the weighting coefficients are precise replicas of samples of the time impulse response.

FIG. 3 is illustrative of the problem and shows a typical aliased spectrum corresponding to 8-times oversampling (eight samples per symbol duration) of a root raised cosine filter with $\alpha$ = 0.22. Note how the spectrum has also been distorted by truncation of the number of taps to 65 (centre tap plus 32 taps on either side). The abscissa (x-axis) has been scaled to 1024 steps, representing an eight-times nominal signal rate. From the graph, a FIR filter so constructed offers adjacent channel protection of the order of about forty decibels (40dB) and would be capable of satisfying moderately low-grade requirements. For a high specification filter, however, whether at the transmitter or receiving end, the number of taps may well exceed one hundred and this then represents a significant computation load and power drain. For example, in UMTS where the chip rate is 3.84 MChip/s, for a filter with 100 taps then the processing load would be 3.8 GFLOP/s (giga-floating point operations per second). Attempts to reduce the work load by truncation of the filter coefficient word length would, however, result in potentially unacceptable distortion within the spectrum, as will now be appreciated. The conventional FIRT filter must therefore maximise use of symmetries within its configuration.

Decimators or interpolators which use all-pass component sections are highly efficient methods of achieving jointly sample rate reduction and low pass filtering. The theory of decimation/polyphase filtering is described in Valenzuela R. A., Constantinides A. G: "Digital signal interpolation schemes for efficient interpolation and decimation", Proc. IEE, Pt. G, 130, No. 6, Dec. 1983, pp.225-235, and Bellanger M. G., Bonnerot G, and Coudreuse M.: "Digital filtering by polyphase network", IEEE Trans. ASSP-24, 1976, pp109-115. While decimators do not normally have controlled time domain impulse response properties, they do have well controlled frequency responses and low computation load and are highly suitable for removing aliases from the original raised cosine filter.

Although not acting in the fashion of a filter, multi-rate interpolators and decimators have found utilisation in sonar systems in which they act to time align signals from multiple acoustic sensors to support beam-forming.

Summary Of The Invention

In accordance with a first aspect of the invention, there is provided a method of applying filtering to a signal propagating through a radio frequency signal processing chain, the method comprising: applying the signal to a multi-rate filter providing an approximation of a desired impulse frequency response characteristic within the RF signal processing chain.

The RF signal processing chain includes a transmitter and a receiver, and the method may further comprise: applying multi-rate filtering to the signal at least once within at least one of the transmitter and the receiver.

Preferably, the RF signal processing chain includes a pulse-forming filter, and the method further comprises: applying the signal in series to the multi-rate filter and the impulse-forming filter to attain a frequency impulse response that has a band-pass characteristic attributable to the pulse-forming filter and an anti-alias characteristic attributable to the multi-rate filter.

The method generally functions to provide: over-sampling of the signal at a relatively high rate within the multi-rate filter; and over-sampling of the signal at a relatively low rate within the pulse-forming filter.

In one embodiment, the multi-rate filter is a decimator and the signal is applied in sequence to the decimator and the pulse-forming filter, and wherein a sampling rate in the pulse-forming filter is in the approximate range of between two and three times a symbol rate of the signal incident thereto.

In another embodiment, the multi-rate filter is an interpolator and the signal is applied in sequence to the pulse-forming filter and the interpolator, and wherein a sampling rate in the pulse-forming filter is in the approximate range of between two and three times a symbol rate of the signal incident thereto.

In another aspect of the present invention there is provided a filter configuration arranged to provide frequency isolation to a signal incident thereto, the filter configuration forming part of a radio frequency signal processing chain, the filter configuration comprising: a multi-rate filter providing an approximation of a desired impulse frequency response characteristic within the RF signal processing chain.

The RF signal processing chain typically includes a transmitter chain and a receiver chain and wherein at least one of the transmitter chain and the receiver chain includes at least one multi-rate filter.

Preferably, the RF signal processing chain includes a pulse-forming filter coupled to the multi-rate filter, wherein the pulse-forming filter defines a band-pass characteristic for the filter configuration and the multi-rate filter provides an anti-alias rejection for the filter configuration.

In another aspect of the present invention there is provided a method of filtering a digital pulse, the method comprising: filtering out anti-alias frequencies associated with the digital pulse in a multi-rate filter configured to operate at a first clocking rate; and defining a pass-band for the digital pulse through use of a digital pulse-forming filter configured to operate at a second clocking rate, the second clocking rate being relatively low with respect to the first clocking rate and such that the digital pulse-forming filter has a reduced processing load for a given impulse frequency response as compared with a processing load associated with achieving the given impulse frequency response through filtering of the digital pulse in a pulse-forming filter alone.

In yet another aspect of the present invention there is provided a digital pulse shaping filter arrangement comprising a concatenation of a multi-rate filter and a pulse shaping filter, the multi-rate filter configured as at least one of a decimator and an interpolator and wherein: the multi-rate filter supports a characteristic that acts to filter out anti-alias frequencies associated with incident digital pulses and the multi-rate filter is configured to operate at a first clocking rate; and the pulse-forming filter defines a pass-band for incident digital pulses and the pulse-forming filter is configured to operate at a second clocking rate relatively lower with respect to the first clocking rate and such that the digital pulse-forming filter has a reduced processing load for a given impulse frequency response as compared with a processing load associated with achieving the given impulse frequency response through filtering of the digital pulse in a pulse-forming filter alone.

A pulse shaping filter in the transmitter can be a band-pass digital filter, such as a finite impulse response filter (FIR) constructed with many taps, with it being preferred that a multi-rate filter of the preferred embodiment is utilised within a mobile unit (whether in the transmit chain or the receive chain) and irrespective of whether the mobile (subscriber) unit supports bi-directional communication or is merely responsive to broadcast transmissions or pager.

The present invention thus reduces the connection between computation load and spectrum performance by transferring part of the filtering process to a specialised decimation or interpolation structure of a multi-rate filter. Computational load is therefore limited to a maximum of twice the sampling rate.

The present invention advantageously provides an improved filter that can be implemented in software with reduced computational load and at reduced cost. Consequently, when employed within a mobile subscriber unit, such as a cellular phone or multi-media device, the mobile subscriber unit benefits from improved battery life. Use of multi-rate filters within receiver and transmit chains is therefore extremely efficient as regards both cost and operational performance (from battery drain and processing perspectives).

Description Of The Drawings

In order that the present invention can be more fully understood and to show how the same may be carried into effect, reference shall now be made, by way of example only, to the Figures as shown in the accompanying drawing sheets wherein:

FIG. 1 shows a typical installation of a pulse shaper in a digital communications system;
FIG. 1a shows a typical realisation of a digital raised cosine filter;
FIG. 2 shows a synthesis of the raised cosine spectrum;
FIG. 3 shows an aliased and truncated spectrum for an $8\times$over-sampled and truncated (65-tap) root raised cosine filter;

FIG. 4 shows the impulse responses of a raised cosine filter and rooted-raised cosine filter;

FIG. 5 shows a communication device arranged to support a filter configured according to a preferred embodiment of the present invention;

FIG. 6 shows an interpolator for a preferred transmitter chain of FIG. 5, the transmitter chain using second degree all-pass networks;

FIG. 7 shows a decimator for a preferred receiver chain of FIG. 5, the receiver chain using first degree all-pass networks;

FIG. 8 is a block diagram of a filter configuration in a transmit chain of a further embodiment of the present invention;

FIG. 9 is a block diagram of a filter configuration in a transmit chain of a further embodiment of the present invention;

FIG. 10 contrasts individual frequency responses of a decimator (solid-line) with a RRC FIR filter (dashed line);

FIG. 11 shows the frequency response of a combination decimator and RRC filter of and ideal RRC response according to FIGs. 8 or 9;

FIG. 12 shows an expanded scale of frequency response of FIG. 11; and

FIG. 13 compares exact and processed RRC impulse responses from the cocatenation of multi-rate and FIR filters according to FIGs. 8 or 9;

FIG. 14 is a block diagram of a portion of a receiver chain configuration according to another embodiment of the present invention; and

FIG. 15 shows the frequency response of the decimator of FIG. 14.

## Detailed Description Of The Preferred Embodiments

There will now be described by way of example the best mode contemplated by the inventors for carrying out the invention. In the following description, numerous specific details are set out in order to provide a complete understanding of the present invention. It will be apparent, however, to those skilled in the art that the present invention may be put into practice with variations of the specific.

The invention shall be described in relation to the Root Raised Cosine (RRC) filter. Complementary filters in the receive and transmit chains provide the RRC function.

The full raised cosine window has time domain impulse response:

$$h(t) = \frac{\sin(\pi\ Bt)}{\pi\ Bt} \frac{\cos(\alpha\pi\ Bt)}{1\text{-}(2\alpha\pi\ Bt)^2} \tag{1}$$

while the root raised cosine spectrum has the following impulse response:

$$h(t) = \frac{4\alpha\sqrt{B}}{\pi} \frac{\cos\big((1+\alpha)\pi\,Bt\big) + \dfrac{\sin\big((1-\alpha)\pi\,Bt)\big)}{4\alpha tB}}{1 - (4\alpha\pi\,Bt)^2}$$

$$(2)$$

FIG. 4 shows the impulse responses defined by equations (1) and (2). The raised cosine filter response is identified by the solid line 180; the root raised cosine filter response is represented by a dashed line 182. The auto-convolution of the root raised cosine impulse response will equate to the raised cosine impulse response.

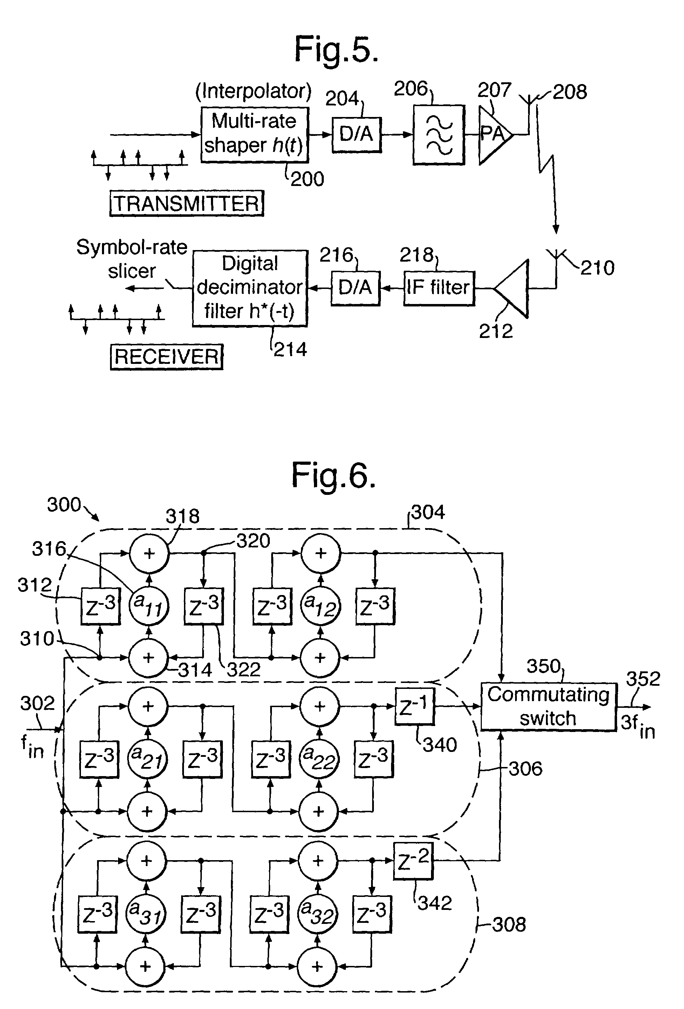

FIG. 5 shows a transceiver configuration according to a preferred embodiment of the present invention; the transceiver comprising a transmit chain and a receiver chain. The transmit chain, amongst other components know to the skilled addressee, comprises a multi-rate filter 200 supporting a raised-cosine function. An output from the multi-rate filter is typically coupled to a power amplifier 202 via a digital to analog converter 204 and an analog anti-aliasing filter 206 satisfying Nquist sampling criteria. Following amplification (in power amplifier 207), a suitable modulated signal can be transmitted from an antenna 208. As regards the receiver chain, after signal recovery (at an antenna 210) and amplification in amplifier 212, the signal is applied to a digital decimator (realised by a multi-rate filter) 214 via a series combination of, typically, an intermediate frequency (IF) filter 216 and an analog to digital converter 218.

The advantage of the present invention is that the multi-rate filter (either in its guise as an interpolator or decimator) provides a highly efficient mechanism for refining spectrum outside a selected passband. Moreover, the use of multi-rate filter is achieved through the use of very few weighting coefficients. In fact, the workload of a multi-rate filter (employed within the preferred embodiments of the present invention) is not much greater than a 2-tap filter at the final sampling rate. Interpolation can be implemented by combining all-pass digital phase shifting elements to produce a quasi-elliptic filter characteristic.

As will be appreciated, a multi-rate filter is a recursive filter that effectively operates with two or more parallel taps/all-pass sections. The multi-rate filter is configured to filter input signals with spectral components below half the clock rate $f_c$ (i.e. $f_{in}=f_c/2$) to satisfy Nyquist's requirements and so to achieve Nyquist aliasing and then to apply a band-stop to an upper frequency band whilst sampling at a reduced rate. In the simple case of 2-tap implementation, the multi-rate filter operates to discard/reject the top half of the incident spectrum ($f_{in}$) and then to sample at half rate effectively to reject all frequencies above a quarter of the original spectrum (i.e. attenuation is applied to frequencies in the range $f_c/4$ to $3f_c/4$ and essentially from $f_{in}/4$ to $f_{in}$). The process is iterative, so output samples could be applied to an input of the multi-rate filter to once more attenuate the upper reaches of the spectrum and to reduce the final sampling rate by a factor of four (in this particular instance of a 2-tap configuration). With the multi-rate filter preferably implemented as code, a sampled output may merely be fed into the multi-rate input (by virtue of operation of a sub-routine), although it is equally possible to provide a combination of successive multi-rate filters to avoid increased signal timing complexity.

In essence, therefore, the multi-rate filter provides an output that is notched but sampled at an appropriate rate to alias or otherwise spread a frequency band of particular interest across a new sampling rate.

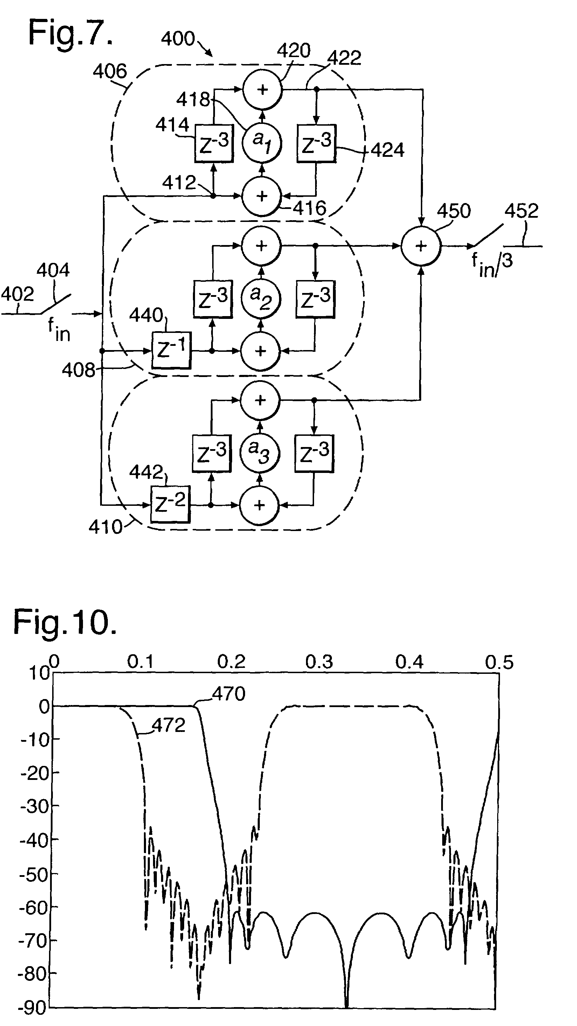

Turning to FIG. 6, a 3-way interpolator 300 for use in a transmit chain of FIG. 5 is shown. An input signal ($f_{in}$) 302 is applied in parallel to three parallel all-pass filter arms 304-308; the interpolator 300 in this instance therefore provides frequency attenuation to a factor of three. Each arm, in this exemplary form, contains a pair of serially coupled all-pass sections. Each all-pass section contains an input node 310 that is split to provide the input signal $f_{in}$ to a first time delay ($Z^{-3}$) 312 (commensurate with the number of arms in the multi-rate filter 300) and a first adder or summation unit 314. An output from the first adder 314 is coupled to an instantaneous weighting coefficient ($a_{xy}$) 316 associated with the all-pass filter section. An output from the instantaneous weighting coefficient ($a_{xy}$) 316 provides a first input a second adder 318, with the second adder 318 receiving a second input from the time-delayed input signal from first time delay ($Z^{-3}$) 312. An output from the second adder 314 is provides an output from the all-pass filter section 320, which output is tapped and time-delayed in a second time delay ($Z^{-3}$) 322 (commensurate with the number of arms in the multi-rate filter 300). An output from the second time delay 322 (i.e. a time delayed version of the output signal 320) provides a second input to the first adder 314. In a polyphase implementation, multiple all-pass filter sections are coupled in series, with the output from a preceding stage providing an input to a succeeding stage.

Each instantaneous weighting coefficient ($a_{xy}$) of each all-pass section will generally be different. Additionally, dependent upon the number of parallel all-pass filter arms 304-308, certain of the arms will include additional time delays 340-342 either located on a final output or on an input to some of the parallel arms 304-308. These additional time delays (identified as having delay $Z^{-1}$ and $Z^{-2}$ and relating to the output clock rate in the 3-tap multi-rate filter of FIG. 6) compensate for phase delay and provide a cancellation mechanism for the upper frequencies that the multi-rate filter 300 is operable to reject, as will be understood.

Use of a three-way multi-rate configuration is particularly advantageous in wireless (RF) applications, since refinement of the spectrum is achieved relatively quickly (at a moderate granularity) and with a generally acceptable processing workload.

In summary, therefore, the multi-rate filter has a polyphase network and each arm of the polyphase network has two all-pass networks; each having a load of two summing functions and one multiplication function per clock. Each arm is only clocked once every third input sample Of course, the workload can be reduced by exploiting repetitive structures and symmetries between coefficients of the filter in the various paths.

Each arm 304-308 usually has a similar number of stages, i.e. all-pass filter sections, with a succession of stages providing an improved linear phase characteristic for the parallel arms. The various arms, some of which are subject to additional delays to adjust for phase, are combined at a commutating switch 350 that acts to consolidate incident signals (output from the potentially polyphase parallel all-pass filter arms 304-308) into a composite output signal 352 of frequency $3f_{in}$ (and improved adjacent channel isolation/reduced splatter). The composite output signal is then applied to the D/A 204 of FIG. 5.

In relation to the interpolator configuration (of FIG. 6), it will be understood that each arm 304-308 is operational every input sample, although respective outputs from these parallel arms are only cyclically engaged by the commutating switch 350 once every three outputs (or n outputs for n parallel arms).

With an input sample rate of six (6) times a channel symbol rate, the total load per channel symbol (within the structure of FIG. 6) is eight addition functions and four multiplication functions. In contrast, a 33-tap RRC FIR filter is clocked at twice the channel symbol rate and therefore has a workload of 66 multiplication functions and 66 add functions per channel symbol. The workload performance of a device incorporating a multi-rate filter in accordance with the principles of the present invention is, accordingly, much better than an 8x over-sampled straight FIR filter with 65 taps which would have a computation load of 520 multiplies and 520 adds per channel symbol.

FIG. 7 shows a decimator 400 as would preferably be used in a receiver chain constructed in accordance with the principles of the present invention The decimator is preferably realised as a multi-rate filter having an input signal ($f_{in}$) 402 applied in switched sequence (through switch 404) to, in this specific embodiment, three parallel all-pass filter arms 406-410. The decimator 400 in this instance therefore provides frequency reduction of a factor of three. Each arm 406-410, in this exemplary form, contains a single all-pass section. Each all-pass section contains an input node 412 that is split to provide the input signal $f_{in}$ to a first time delay ($Z^{-3}$) 414 (commensurate with the number of arms in the multi-rate filter 400) and a first adder or summation unit 416. An output from the first adder 416 is coupled to an instantaneous weighting coefficient ($a_1$) 418 associated with the all-pass filter section. An output from the instantaneous weighting coefficient ($a_1$) 418 provides a first input a second adder 410, with the second adder 420 receiving a second input from the time-delayed input signal from first time delay ($Z^{-3}$) 414. An output from the second adder 420 provides an output from the all-pass filter section 422, which output is tapped and time-delayed in a second time delay ($Z^{-3}$) 424 (commensurate with the number of arms in the multi-rate filter 400). An output from the second time delay 424 (i.e. a time delayed version of the output signal 422) provides a second input to the first adder 416. In a polyphase implementation, multiple all-pass filter sections are coupled in series, with the output from a preceding stage providing an input to a succeeding stage.

Each instantaneous weighting coefficient ($a_2$) of each all-pass section will generally be different. Additionally, dependent upon the number of parallel all-pass filter arms 406-410, certain of the arms will include additional time delays 440-442 either located on a final output or on an input to some of the parallel arms 406-410. These additional time delays (identified as having delay $Z^{-1}$ and $Z^{-2}$ and relating to the output clock rate in the 3-tap multi-rate filter of FIG. 7) compensate for phase delay and provide a cancellation mechanism for the upper frequencies that the decimator (multi-rate filter) 400 is operable to reject, as will be understood.

In the summary, therefore, the multi-rate filter may have a polyphase network and each arm of the polyphase network having one or more all-pass networks; each having a load of two summing functions and one multiplication function per clock. Each arm is only clocked once every third input sample (by operation of the switch 404). Of course, the workload can be reduced by exploiting symmetries between coefficients of the filter in the various paths.

Each arm 406-410 usually has a similar number of stages, i.e. all-pass filter sections, with a succession of stages providing an improved linear phase characteristic for the parallel arms. The various arms, some of which are subject to additional delays to adjust for phase, are combined at a summing unit (multiplexer) 450 that acts to consolidate incident signals (output from the potentially polyphase parallel all-pass filter arms 406-410) into a composite output signal 452 of frequency $f_{in}/3$ (and improved adjacent channel isolation/reduced splatter). More specifically, the phase response of the various parallel arms is utilised to cancel an upper portion of the frequency band through a vector summation technique, with the output from the summing unit 450 being sampled at a fraction of the input rate (and specifically a reciprocal of the number of arms).

Although not shown in a polyphase configuration, multiple low-pass filter sections may be employed.

By way of generic explanation, if x is the number of taps, then x is also the number of parallel paths/arms through the multi-rate filter and, either: i) x is the commutating switch rate to provide a $3f_{in}$ output (for an interpolator); or 1/x is the sampling rate (for a decimator in a receiver chain). Successive iterative applications of a resultant spectrum to the multi-rate filter within receiver and transmitter architectures (of the preferred embodiments of the present invention) thereby reduce by half or one third the processing demands placed on the digital signal processor (DSP), with the processing load never more than twice the load experienced in the first stage. In other words, only the first multi-rate stage operates at the full sampling rate, which contrasts with a convention FIR filter approach where processing is entirely proportional to the number of taps (which must each operate at the full sampling rate).

As will now be understood, the general strategy is to run the RRC function, which has the greatest number of coefficients, at twice the chip rate (in the context of a CDMA-based system).

Use of second order all-pass filters (in a decimator of a receiver chain according to a preferred embodiment of the present invention) can achieve an adjacent channel rejection better than 65dB, whilst single stage all-pass filters in each parallel arm are able to achieve an adjacent channel rejection of the order of 45dB. The use of the multi-rate filter in one or both of the receiver and transmit chains results in the attenuation (i.e. cutting out) of frequencies that would otherwise alias in the filtering stage, with iteration refining the pass band and limiting adjacent channel interference.

In summary, the extended band stop region allows an RRC multi-rate filter with a very low clocking rate to be interfaced efficiently to an A/D converter with a high clocking rate. The decimation factor is increased by inserting additional filter sections.

Decimator coefficients for use in FIG. 6 may be based on a number of sources works, including R. Ansari and B. Liu: "Efficient sampling rate alteration using recursive (IIR) digital filter", IEEE Trans. ASSP-31, 1983, pp.1366-1371. Typical values for the weighting coefficients are:

$$a_{xy} = 0.525392\ 0.057008$$

$$0.746502\ 0.162022$$

$$0.895940\ 0.347291$$

An all-pass filter section has a response given by:

$$H(z) = \frac{a + z^{-N}}{1 + a \cdot z^{-N}} \tag{3}$$

The decimators/interpolators are constructed from several such sections with differing pole locations. For example, the decimator of FIG. 6 has IMPULSE response:

$$H(z) = \frac{a_1 + z^{-3}}{1 + a_1 \cdot z^{-3}} + z^{-1}\frac{a_2 + z^{-3}}{1 - a_2 \cdot z^{-3}} + z^{-2}\frac{a_3 + z^{-3}}{1 - a_3 \cdot z^{-3}} \tag{4}$$

and frequency response:

$$H(\omega) = \frac{a_1 + e^{-3j\omega T}}{1 + a_1 \cdot e^{-3j\omega T}} + e^{-j\omega T}\frac{a_2 + e^{-3j\omega T}}{1 - a_2 \cdot e^{-3j\omega T}} + e^{-2j\omega T}\frac{a_3 + e^{-3j\omega T}}{1 - a_3 \cdot e^{-3j\omega T}} \tag{5}$$

Turning now to FIG. 8, there is shown a filter configuration in a transmit chain 455 of a further embodiment of the present invention. The structure of FIG. 8 is essentially that of FIG. 5, although a multi-rate interpolator 456 is preceded in the transmit chain 455 by an FIR filter 458. The FIR filter 458 operates at a relatively low sampling rate (with relatively few taps) to provide band-pass capabilities, whilst the multi-rate interpolator over-samples to provide an anti-alias function with reduced processing overhead. In other words, the FIR is therefore run in cascade with the multi-rate, with the FIR filter 458 run at a low sampling rate to provide RRC (or other desired characteristic) spectral shaping. The FIR filter, as will be understood, supports a well-defined cut-off at the band edge, whilst its deficiency in addressing anti-alias problems is addressed by the cocatenation of the multi-rate filter.

The multi-rate interpolator 456 and, generally, the FIR filter 458 may be supported by a computer program product, with the blocks in the diagram representative of code loaded within a suitable storage medium, e.g. an EEPROM.

With regard to FIG.9, there is shown a filter configuration in a receiver chain 460 of another embodiment of the present invention. Again, the basic structure of the receiver chain 460 is akin to that shown in relation to FIG. 5, although a multi-rate decimator (filter) 462 is followed by a FIR filter 464. In slightly more detail, an input signal to the multi-rate decimator is over-sampled (in a preferred embodiment) by a factor of six, with the multi-rate providing decimation by a factor of three. Consequently, an output 466 from the decimator 462 is clocked into the FIR filter at twice a nominal symbol/chip rate (hereinafter referred to generically as "symbol rate"). The FIR filter 464 operates at a rate of two samples per symbol/chip to provide an output signal having sharp spectral characteristics.

It should be emphasised that the use of 6 times over-sampling with respect to the multi-rate filter (in either an interpolating or decimating function) and the corresponding use of a triplicate (three times) decimator/interpolator is preferred, it will be appreciated that these factors are selected to provide reasonable FIR processing load for acceptable adjacent channel interference (in the transmit path) or acceptable isolation of a wanted signal (in the receive path). Other factors could, of course, be considered, which factors may provide non-integer sampling rates for successive components. However, it is preferred that signals either incident to a multi-rate interpolator or exiting from a multi-rate decimator are at about a factor of three times the symbol/chip rate and preferably at about twice the symbol/chip rate. Clearly, higher factors could be applied, but processing load increases significantly with respect to FIR filter operation for factors above about three.

FIG. 10 contrasts frequency response (solid line 470) of a multi-rate RRC filter with a RRC FIR filter (dashed line 472), as envisaged in relation to FIGs. 8 or 9. The x-axis runs from zero to half the input sample rate. The RRC FIR filter (in this particular instance) is clocked at twice the symbol rate and has 33 taps extending to $\pm16$ samples or

eight symbols while the input (to the cascaded multi-rate filter) is clocked at 6x the symbol rate, as described in relation to FIG. 9.

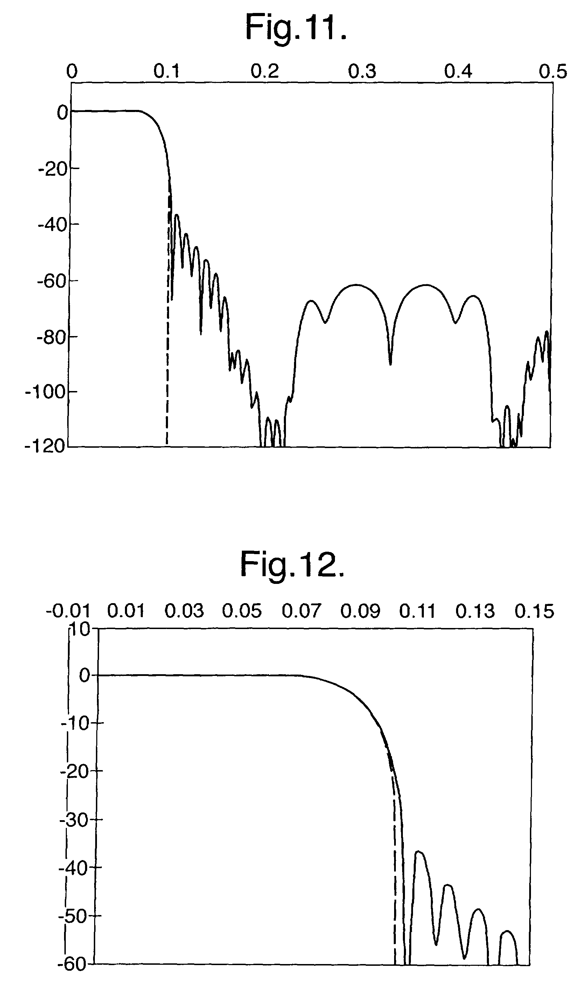

FIG. 11 is a spectral representation of a combined/resultant frequency response achieved through the use of cocatenated multi-rate and FIR filters. It should be noted that the pass-band has spread slightly due to the truncation of the original FIR filter. FIG. 11 is therefore, in fact, the combination of the different frquency responses shown in FIG. 10.

FIG. 12 provides an expanded view of the impulse response of FIG. 11 in relation to the cocatenated filter configuration of FIGs. 8 and 9.

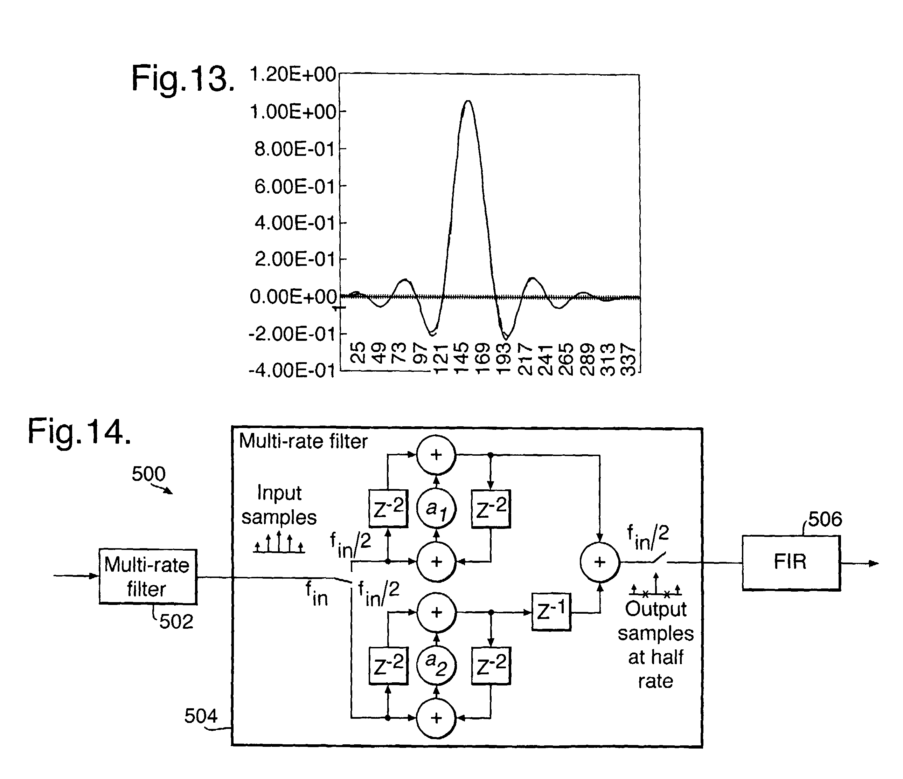

FIG. 13 compares exact (i.e. defined by eqn. 1) and processed RRC time domain impulse responses from the concatenated multi-rate and FIR filters of FIGs. 8 and 9. This example would give an adjacent channel protection (ACP) of the order of -54dB, while if the number of RRC taps is increased by approximately fifty percent to forty-nine (in the FIR filter section) the first side lobe falls to better than -40dB and the ACP increases to about -59dB.

The filter circuits of the present invention are conveniently constructed as a semiconductor chip, preferably as an Application Specific Integrated Circuit (ASIC), as is well known in the art. Alternatively, the filter circuits could be implemented as a Floating Point Gate Array (FPLA).

By a judicious combination of a finite impulse response (FIR) filter to control the pass-band part of the response and a decimation by the multi-rate filter (as seen in the spectra of FIGs. 10 to 12) to reduce the sample rate from that of the A/D converter and control aliases, a much more efficient structure is realised.

The rate-halving decimating low-pass filter of FIG. 12 decimates the input samples with a band limited frequency response and provides a halved sample rate at the output. The z-plane response of the whole filter, based on the output sampling rate is:

$$H(z) = \frac{a_1 + z^{-2}}{1 - a_1 \cdot z^{-2}} + z^{-1} \frac{a_2 + z^{-2}}{1 - a_2 \cdot z^{-2}} \tag{6}$$

and on the unit circle in the z-plane the frequency response is given by:

$$H(e^{j\omega T}) = \frac{a_1 + e^{-2j\omega T}}{1 - a_1 \cdot e^{-2j\omega T}} + e^{-j\omega T} \frac{a_2 + e^{-2j\omega T}}{1 - a_2 \cdot e^{-2j\omega T}} \tag{7}$$

Equations (6) and (7) can be interpreted that the input is sampled at the same rate as the output, but alternate input samples are constrained to be zero (as shown in the figure) and are reconstructed by decimation at the output. The desired overall frequency response, referred to the output sampling rate, has the form of an ideal low-pass filter with a frequency response of the form:

$$\begin{aligned} |H(\omega T)| &= 1, \quad \pi/4 < \omega T_{\mathrm{mod}\,2\pi} < \pi/4 \\ &= 0, \quad \pi/4 < \omega T_{\mathrm{mod}\,2\pi} < \pi/2 \end{aligned} \tag{8}$$

The design of the filter sections for combined low sidelobes and fast transition from pass to stop band involves numerical optimisation techniques for critical applications. However the present invention is rather forgiving of design tolerances and a purely mathematical design, though marginally less precise, is adequate for practical purposes. A known analytical design method is employed and has the advantage of producing standardised coefficient values, some of which are presented below for reference purposes.

There now follows a simple procedure to compute the two filter coefficients $a_1$ and $a_2$ with a MatLab program. Table I, based on this design, shows the relation between normalised transition band width and stop band attenuation for third order interpolation filters based on first order all-pass sections:

Table I:

| Examples of filter section designs | | | |
|---|---|---|---|
| **Transition band** | **Stop band attn.(dB)** | **$a_1$** | **$a_2$** |
| 0.1 | -39.2 | 0.236471 | 0.714542 |
| 0.15 | -47.5 | 0.187431 | 0.65616 |
| 0.2 | -56.0 | 0.157606 | 0.61484 |
| 0.25 | -65.2 | 0.138025 | 0.584683 |

The co-efficients $a_1$ and $a_2$ of equation 6 are found as functions of the design parameters (stop band ripples and transition region width) by the following rules:

(i) Choose a transition band $f_t$ in the range say 0.1 to 0.25 (relative to the output sampling rate). The width of the transition band governs the sharpness of the transition from pass band to stop band (it is defined as the distance from the -3 dB point to the first point in the stop band where the attenuation reaches its equi-ripple value) and there is a trade-off between transition band width and stop band side lobes. A narrow transition band leads to poor stop band attenuation and the auto-correlation function of the section's impulse response is likely to exhibit ripples and $f_t$'s near the high end of the range have been found to be most useful.
(ii) Calculate the following elliptic filter parameters:

$$k = \tan^2\left(\tfrac{1}{4}(\pi - \omega_t)\right)$$

$$e = \tfrac{1}{2}\frac{1 - \sqrt[4]{1 - k^2}}{1 + \sqrt[4]{1 - k^2}}$$

$$q = e + 2e^5 + 15e^9 + 150e^{13}$$

$$k_t = 4q^{5/2} \tag{9}$$

The pass amplitude band ripple $d_p$ and stop band amplitude $d_s$ are given by:

$$d_p = 1 - \sqrt{1/(1+k_t)}$$

$$d_s = \sqrt{k_t/(1+k_t)} \tag{10}$$

and finally the frequencies of minimum response are computed from certain Theta functions:

$$\omega_i = \frac{2q^{1/4}\sum_{m=0}^{\infty}(-1)^m q^{m(m+1)}\sin\left[(2m+1)\pi i/n\right]}{1 + 2\sum_{m=1}^{\infty}(-1)^m q^{m^2}\cos\left[2m\pi i/n\right]} \tag{11}$$

Only the first four or five terms in the infinite sums are required for adequate accuracy. As an example, if each of the parallel all-pass sections are constrained to be first order, their two coefficients are:

$$b_i = \frac{\left[\left(1 - k\omega_i^2\right)\left(1 - \omega_i^2 / k\right)\right]^{1/2}}{1 + \omega_i^2} \quad i = 1,2$$

$$a_i = \frac{1 - b_i}{1 + b_i} \tag{12}$$

There now follows a MatLab listing of a program for filter coefficient generation (which coefficients have been used to generate the frequency spectral shown in the accompanying drawings).

PROGRAM:

```
ft=0.1
n=5
kk=tan(0.25*pi*(1-ft*2))^2
n1=(1-kk^2)^0.25
e=0.5*(1-n1)/(1+n1)
q=e+2*e^5+15*e^9+150*e^13
kt=4*q^2.5
ds=(kt/(1+kt))^0.5
dp=1-(1/(1+kt))^0.5

for k=1:2
num=0;
den=0;
for m=0:5
num=num+(-1)^m*q^(m*(m+1))*sin((2*m+1)*pi*k/n);
den=den+(-1)^(m+1 )*q^((m+1)^2)*cos(2*(m+1)*pi*k/n);
end
num,den
omega(k)=2*q^0.25*num/(1+2*den)
b(k)=((1-kk*omega(k)^2)*(1-omega(k)^2/kk))^0.5/(1+omega(k)^2)
a(k)=(1-b(k))/(1+b(k))
end
```

Some intermediate results for n=5, ft=0.1 provide:

```
kk = 0.5279      n1 = 0.9216
e = 0.0204       q = 0.0204
kt = 2.3782e-004
ds = 0.0154 (-38.25 dB)      dp = 1.1889e-004
```

At first frequency:

```
num = 0.5874      den = -0.0063
omega(1) = 0.4497
b(1) = 0.6175      a(1) = 0.2365 [1st. coeff. value]
```

At second frequency:

```
num = 0.9513      den = 0.0165
omega(2) = 0.6961
b(2) = 0.1665 a(2) = 0.7145 [2nd. Co-efficient. value]
```

FIG. 14 is a block diagram of a portion of a receiver chain 500 configuration according to another embodiment of the present invention. FIG. 14 departs from the basic structure of FIG. 9 by employing multiple cascaded multi-rate filter stages 502-504. Multi-rate stage 504 is shown in detail, and represents a first order divide-by-two decimator function. Cocatenated multi-rate filters can have identical or different decimator functions. In the specific instance of FIG. 14, it is envisaged that successive multi-rate stages operate to receive 12x over-sampled signals and 6x over-sampled signals, respectively, whereby the FIR filter 506 operates on the basis of a signal that is three time over-sampled. Of course, the FIR filter 506 now requires more taps and a higher clocking rate than the FIR filter 464 in FIG. 9, but performance is correspondingly improved.

Of course, multiple mult-rate stages can be employed in the either or both of the receiver and transmit chains, with each multi-rate filter being either first or multi-order in its construction (i.e. each parallel arm can contain one or more all-pass filter sections).

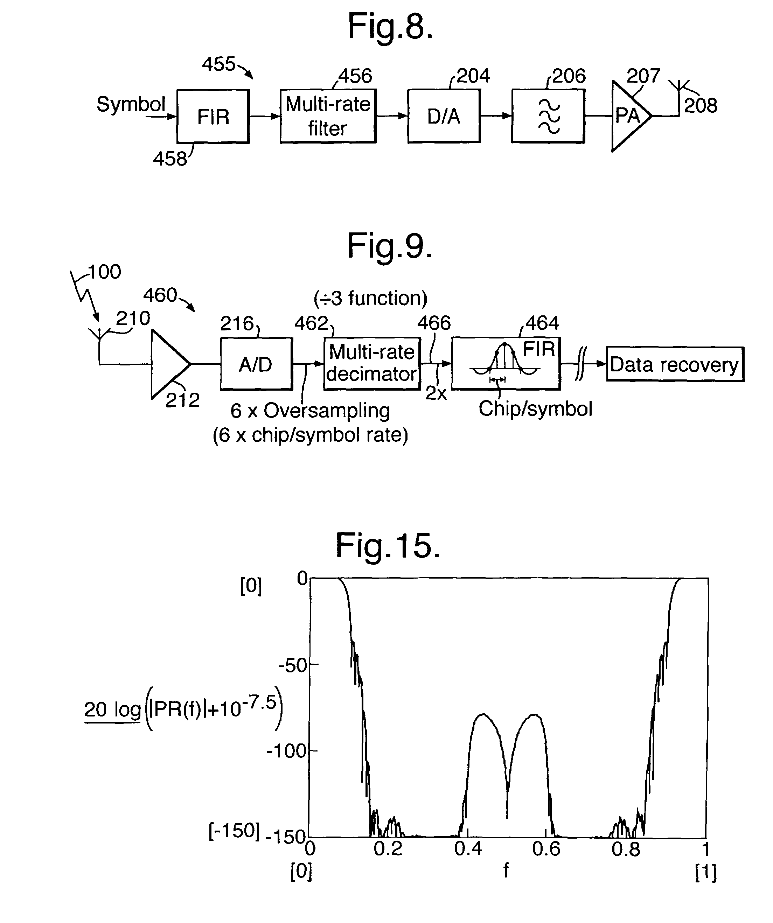

FIG. 15 shows the frequency response of the decimator of FIG. 14. More specifically, FIG. 15 shows the result of cascading two $2\times$ decimation filters as shown in FIG. 14 and one RRC filter clocked at 3 times the chip rate. The input sample rate is $2\times2\times3 = 12$ times the chip rate. The RRC filter is truncated symmetrically to 49 taps ($\pm24$ + centre). The greatest spurious response here is about -80dB. For an UTRA application, where the chip rate is 4.096 MHz and the channel spacing is 5 MHz, the response at the cross over region between two channels is -26dB. To obtain the equivalent results without use of the decimation filters of the present invention, the clock rate in the RRC would have to be increased 8 fold to 24 per chip and the number of taps would also have to increase to $8 \times 48 +1 = 385$.

Embodiments of the invention may be implemented as a computer program product for use with a processor-based system, such computer program products supporting code to implement the multi-rate filter function. Such implementation may include a series of computer instructions fixed either on a tangible medium, such as a computer readable media (e.g. a diskette, CD-ROM, or fixed disk, magneto-optical disks, ROMs, EEPROMs, flash memory or magnetic or optical cards), or fixed in a computer data signal embodied in a carrier wave that is transmittable to a computer system via a modem or other interface device, such as a communications adapter connected to a network over a medium. The medium may be either a tangible medium (e.g. optical or analog communications lines) or a medium implemented with wireless techniques (e.g. microwave, infrared or other transmission techniques). Indeed, for third generation telecommunication system, download of code for the multi-rate filter (from a base station) is envisaged. The series of computer instructions embodies all or part of the functionality previously described herein with respect to the system.

Software embodiments of the invention may be implemented in any conventional computer programming language. For example, preferred embodiments may be implemented in a procedural programming language (e.g. "C") or an object oriented programming language (e.g. "C++"). Furthermore, such instructions may be stored in any memory device, such as semiconductor, magnetic, optical or other memory devices, and may be transmitted using any communications technology, such as optical, infrared, microwave, or other transmission technologies. It is expected that such a computer program product may be distributed as a removable medium with accompanying printed or electronic documentation (e.g. shrink wrapped software), preloaded with a computer system (e.g. on system ROM or fixed disk), or distributed from a server or electronic bulletin board over the network (e.g. the Internet or World Wide Web).

Although the steps of the preferred operating methodology are performed by general or specific-purpose processors or logic circuits (programmed with suitable machine-executable instructions), hardware implementations may be used to perform the steps. Alternatively, the steps may be performed by a combination of hardware and software.

It will, of course, be appreciated that the above description has been given by way of example only and that modifications in detail may be made within the scope of the present invention. For example, the method (and configuration) employed within the preferred embodiment is not restricted to raised-cosine filters and can be applied to any baseband filter profile. Once the filter characteristic has been selected for the system (e.g. RRC), then there is no need for the complementary filters in the receiver chain and the transmit chain to be implemented in an identical/similar fashion. Whilst it is preferred that both the pulse shaping filter function and the matched filter function are implemented as multi-rate filters, it may (in certain instances) be preferably to equip only mobile equipment or even just a transmit chain with a multi-rate filter such that a complementary filter function is realised as a truncated filter. Furthermore, whilst specific embodiments describe the invention is relation to the cocatenation of a multi-rate filter with a FIR filter, it will be appreciated that one could use other digital pulse-shaping filters instead on the FIR filter, e.g. infinite impulse response (IIR).

**Claims**

1. A method of applying filtering to a signal (402) propagating through a radio frequency signal processing chain (455, 460), the method characterised by:

applying the signal to a multi-rate filter (200, 214, 400, 456, 462) providing an approximation of a desired impulse frequency response characteristic (470, 472) within the RF signal processing chain (455, 460).

**2.** The method of claim 1, wherein the RF signal processing chain (455, 460) includes a transmitter and a receiver, and the method further comprises:

applying multi-rate filtering to the signal at least once within at least one of the transmitter and the receiver.

**3.** The method of claim 1 or 2, wherein the RF signal processing chain includes a pulse-forming filter (458, 464), and the method further characterised by:

applying the signal in series to the multi-rate filter (200, 214, 400, 456, 462) and the pulse-forming filter (458, 464) to attain a frequency impulse response that has a band-pass characteristic (472) attributable to the pulse-forming filter (458, 464) and an anti-alias characteristic (470) attributable to the multi-rate filter (200, 214, 400, 456, 462).

**4.** The method of claim 3, further comprising:

over-sampling the signal at a relatively high rate within the multi-rate filter; and
over-sampling the signal at a relatively low rate within the pulse-forming filter.

**5.** The method of claim 3 or 4, wherein the multi-rate filter (200, 214, 400, 456, 462) is a decimator (462, 400) and the signal is applied in sequence to the decimator (400, 462) and the pulse-forming filter (464), and wherein a sampling rate in the pulse-forming filter (464) is in the approximate range of between two and three times a symbol rate of the signal incident thereto.

**6.** The method of claim 5, wherein a sampling rate utilised by the decimator is in excess of about six times the symbol rate.

**7.** The method of any of claims 3 to 6, wherein the multi-rate filter (200, 214, 400, 456, 462) is an interpolator (300, 456) and the signal is applied in sequence to the pulse-forming filter (458) and the interpolator (300, 456), and wherein a sampling rate in the pulse-forming filter (458) is in the approximate range of between two and three times a symbol rate of the signal incident thereto.

**8.** The method of claim 5, wherein a sampling rate utilised by the interpolator is in excess of about six times the symbol rate.

**9.** The method of any of claims 3 to 8, wherein the pulse-forming filter is a finite impulse response (FIR) filter and a sample rate of the FIR filter is selected to be a multiple of the symbol rate.

**10.** A filter configuration arranged to provide frequency isolation to a signal (402) incident thereto, the filter configuration forming part of a radio frequency signal processing chain (455, 460), the filter configuration comprising:

a multi-rate filter (200, 214, 400, 456, 462) providing an approximation of a desired impulse frequency response characteristic within the RF signal processing chain.

**11.** The filter configuration of claim 10, wherein the RF signal processing chain includes a transmitter chain (455) and a receiver chain (460) and wherein at least one of the transmitter chain and the receiver chain includes at least one multi-rate filter.

**12.** The filter configuration of claim 10 or 11, wherein the RF signal processing chain includes a pulse-forming filter (458, 464) coupled to the multi-rate filter(200, 214, 400, 456, 462), wherein the pulse-forming filter (458, 464) defines a band-pass characteristic (472) for the filter configuration and the multi-rate filter provides an anti-alias (470) rejection for the filter configuration.

**13.** The filter configuration of claim 12, wherein:

the multi-rate filter (200, 214, 400, 456, 462) is configured, in use, to provide over-sampling of a digital pulse at a relatively high rate; and
the pulse-forming filter (458, 464) is configured, in use, to provide over-sampling of the digital pulse at a relatively lower rate.

**14.** The filter configuration of claim 13, wherein the multi-rate filter is a decimator (462) arranged first to receive the digital pulse with respect to the pulse-forming filter (464), and wherein the pulse-forming filter has a sampling rate in the approximate range of between two and three times a symbol rate of a signal incident thereto.

**15.** The filter configuration of claim 14, wherein the decimator (400, 462) has a sampling rate in excess of about six times a symbol rate of the digital pulse.

**16.** The filter configuration of claim 13, wherein the multi-rate filter is an interpolator (300, 456) arranged to receive the digital pulse second with respect to the pulse-forming filter, and wherein the pulse-forming filter has a sampling rate in the approximate range of between two and three times a symbol rate of a signal incident thereto.

**17.** The filter configuration of claim 16, wherein the interpolator has a sampling rate in excess of about six times a symbol rate of the digital pulse.

**18.** The filter configuration of any of claims 12 to 17, wherein the pulse-forming filter is a finite impulse response (FIR) filter and a sample rate of the FIR filter is selected to be a multiple of the symbol rate.

**20.** A method of filtering a digital pulse, the method comprising:

filtering out anti-alias frequencies associated with the digital pulse in a multi-rate filter configured to operate at a first clocking rate; and
defining a pass-band for the digital pulse through use of a digital pulse-forming filter configured to operate at a second clocking rate, the second clocking rate being relatively low with respect to the first clocking rate and such that the digital pulse-forming filter has a reduced processing load for a given impulse frequency response as compared with a processing load associated with achieving the given impulse frequency response through filtering of the digital pulse in a pulse-forming filter alone.

**21.** A computer program element comprising computer program code means arranged to make a controller execute procedure to perform of the method of any of claims 1 to 9 or 20.

**22.** The computer program element of claim 21, embodied on a computer readable medium.

**23.** A digital pulse shaping filter arrangement (300, 400) comprising a concatenation of a multi-rate filter (200, 214, 400, 456, 462) and a pulse shaping filter (458, 464), the multi-rate filter (200, 214, 400, 456, 462) configured as at least one of a decimator (400, 462) and an interpolator (300, 456) and wherein:

the multi-rate filter (200, 214, 400, 456, 462) supports a characteristic that acts to filter out anti-alias frequencies associated with incident digital pulses and the multi-rate filter is configured to operate at a first clocking rate; and
the pulse-forming filter (458, 464) defines a pass-band for incident digital pulses and the pulse-forming filter is configured to operate at a second clocking rate relatively lower with respect to the first clocking rate and such that the digital pulse-forming filter has a reduced processing load for a given impulse frequency response as compared with a processing load associated with achieving the given impulse frequency response through filtering of the digital pulse in a pulse-forming filter alone.

# Fig.1.

# Fig.1a.

Output to despreader etc.

**Fig.2.**

Ideal spectrum shape

Raised cosine window

Final "raised cosine" spectrum

**Fig.3.**

$$10 \log\left[\left(\frac{|y_{kk(k)}|}{y_0}\right)^2\right]$$

[0.326522]

[-92.27229]

[0]     k     NB

**Fig.4.**

$$\frac{h(t)}{g(t)}$$

# Fig.5.

# Fig.6.

# Fig.7.

# Fig.10.

# Fig.11.

# Fig.12.

Fig.13.

Fig.14.

# Fig.8.

Symbol → [FIR] → [Multi-rate filter] → [D/A] → [∿∿] → [PA] ▷ ⋎

455, 456, 204, 206, 207, 208, 458

# Fig.9.

100, 460, 210, 216, 462, 466, 464, 212

(÷3 function)

⋎ → [▷] → [A/D] → [Multi-rate decimator] → [FIR] → [Data recovery]

6 x Oversampling
(6 x chip/symbol rate)

2x

Chip/symbol

# Fig.15.

$$20 \log\left(|PR(f)| + 10^{-7.5}\right)$$